# FASCICULE DE BREVET EUROPEEN

(11) **EP 0 433 122 B1**
(45) Date de publication et mention de la délivrance du brevet: **27.10.1993**
(21) Numéro de dépôt: 90403347.9
(22) Date de dépôt: 27.11.1990
(51) Int. Cl.: H01S 3/23, H01S 3/083, H01S 3/108

(54) **Dispositif laser à cavité en anneau**
Laservorrichtung mit Ringresonator
Laser device with ring resonator

(30) Priorité: 01.12.1989 FR 8915879
(43) Date de publication de la demande: 19.06.1991
(73) Titulaire: THOMSON-CSF, 75008 Paris (FR)
(72) Inventeur: Verdiell, Jean-Marc, F-92045 Paris la Défense (FR); Huignard, Jean-Pierre, F-92045 Paris la Défense (FR)
(74) Mandataire: Guérin, Michel

(56) Documents cités:
- OPTICS LETTERS, vol. 14, no. 21, 1 novembre 1989, pages 1189-1191; C.D. NABERS et al.: "Injection locking of a 13-W cw Nd:YAG ring laser"
- IEEE JOURNAL OF QUANTUM ELECTRONICS, vol. 25, no. 2, février 1989, pages 201-207; G. PAULIAT et al.: "Analysis of the build up of oscillations in self-induced photorefractive light resonators"

## Description

L'invention concerne un dispositif laser à cavité en anneau et, plus précisément, un dispositif d'asservissement ou de verrouillage du fonctionnement d'un laser esclave placé dans une cavité en anneau par le faisceau optique émis par un laser maître.

Le verrouillage par injection (ou "injection locking") consiste à asservir un laser dit "esclave", généralement puissant mais ayant de mauvaises propriétés de cohérence (multimode longitudinal) et de divergence (multimode transverse) à un laser de puissance réduite dit "maître" très cohérent et dont la divergence est limitée par diffraction. Pour ce faire, on injecte dans la cavité du laser esclave, la lumière issue du faisceau du laser maître. Une fois le régime de verrouillage par injection (injection-locking) établi, le laser esclave possède les propriétés de cohérence et de divergence héritées du maître tout en conservant l'avantage de sa puissance.

Une des difficultés de cette technique est l'isolation nécessaire entre le maître et l'esclave. En effet, la lumière du maître doit être couplée à l'esclave de manière efficace, mais l'inverse doit être évité sous peine de perturber le maître. Ceci est particulièrement vrai dans le cas de lasers à semi-conducteurs, où une isolation de plus de 30 dB entre esclave et maître est nécessaire.

Pour réaliser cette fonction d'isolation monodirectionnelle, on emploie des isolateurs optiques à effet Faraday qui sont des éléments encombrants, lourds et coûteux.

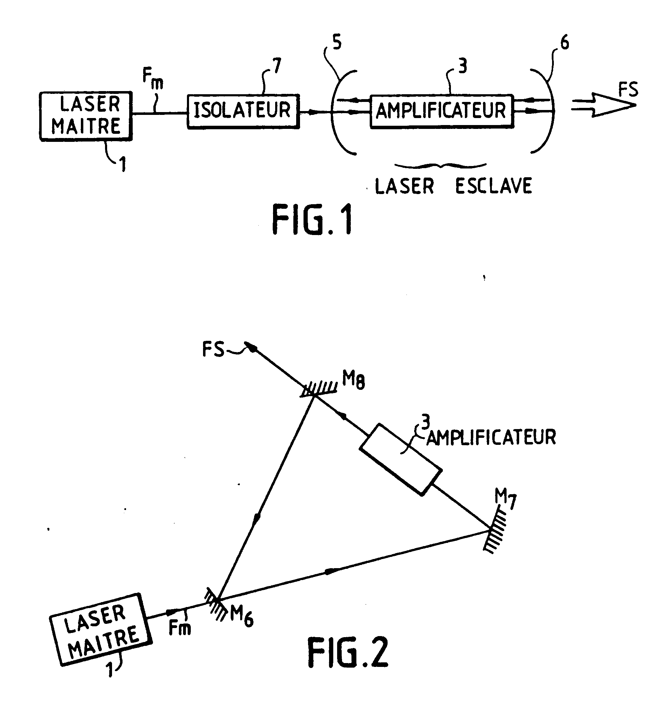

Par exemple, on connaît des dispositifs dans lesquels un laser, appelé laser esclave est constitué par un milieu amplificateur placé dans une cavité optique du type Fabry-Perot. Comme cela est représenté en figure 1, le laser esclave 3 avec sa cavité constituée par les miroirs 5 et 6 reçoit d'un laser maître 1 un faisceau maître Fm. La longueur d'onde du laser esclave et donc la longueur d'onde du faisceau FS émis par la cavité optique est commandée par le faisceau maître Fm.

Il est essentiel pour le fonctionnement du laser maître 1 de se prémunir contre les retours lumineux de la cavité optique esclave vers le laser maître 1. Pour cela on prévoit un isolateur 7 interdisant tout retour de lumière vers le laser maître 1.

On connaît également des dispositifs tels que celui représenté en figure 2 possédant une cavité optique en anneau réalisée par des miroirs M6, M7, M8 et contenant le milieu amplificateur. Le miroir M6 permet l'injection d'un faisceau maître Fm, fourni par un laser maître 1, dans la cavité en anneau.

Le miroir 8 est semi-réfléchissant et permet la sortie du faisceau de sortie FS de la cavité.

D'autre part, dans les dispositifs d'injection locking, la fréquence du laser maître et celle de l'esclave oscillant tous deux librement (sans injection) doivent être sensiblement égales pour tomber dans la plage de verrouillage. Pour cela, on a le choix entre modifier la fréquence du laser maître ou bien de modifier celle de l'esclave en ajustant par exemple la longueur de l'anneau.

La présente invention propose une technique d'injection locking dans les cavités lasers en anneau qui assure un couplage maximum du maître à l'esclave tout en évitant l'emploi d'un isolateur, grâce à l'utilisation d'un milieu non linéaire.

D'autre part, dans les dispositifs d'injection locking à cavité en anneau, la longueur doit être soigneusement ajustée comme cela a été mentionné précédemment. L'invention permet de s'affranchir de cette condition en rendant l'adaptation de la cavité esclave automatique (verrouillage inconditionnel).

L'invention concerne donc un dispositif laser à cavité en anneau comprenant une cavité optique en anneau, un milieu amplificateur situé dans la cavité optique, et constituant un laser esclave, un laser maître émettant un faisceau lumineux (Fm) qui est injecté dans la cavité optique pour commander le laser esclave, caractérisé en ce qu'il comprend un dispositif en matériau non linéaire situé dans la cavité optique recevant le faisceau lumineux du laser maître qui joue le rôle de faisceau sonde (Fs) pour une interaction à deux ondes dans le matériau non linéaire, l'onde optique circulant dans la cavité optique jouant le rôle de pompe.

Les différents objets et caractéristiques de l'invention apparaîtront plus clairement dans la description qui va suivre faite à titre d'exemple en se reportant aux figures annexées qui représentent:
- les figures 1 et 2, des dispositifs connus dans la technique et déjà décrits précédemment;
- la figure 3, un exemple de réalisation du dispositif laser selon l'invention;
- la figure 4, une variante de réalisation du dispositif laser selon l'invention.

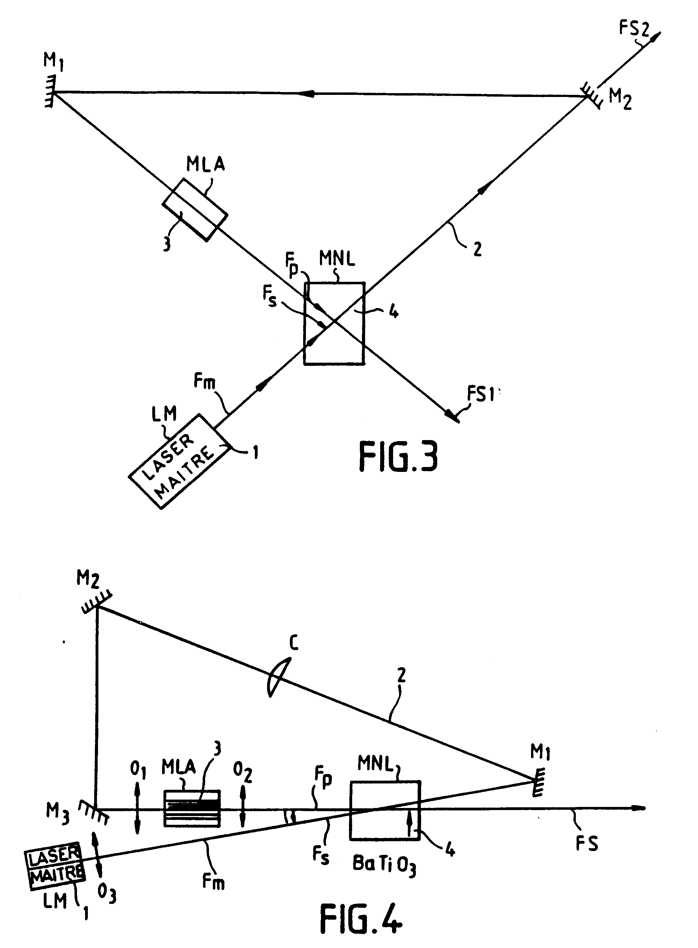

Le dispositif laser de la figure 3 comporte un milieu amplificateur 3 placé dans une cavité en anneau 3 refermée par des miroirs M1 et M2 et un dispositif 4 en matériau non linéaire. Un laser maître 1 émet un faisceau maître Fm vers le dispositif 4 en matériau non linéaire pour être injecté dans la cavité optique 2.

Le laser est formé d'un milieu laser 3 amplificateur MLA (du type semi-conducteur, solide, liquide ou gazeux) voire d'un réseau de ces composants, et d'une cavité en anneau 2.

Le matériau non linéaire du dispositif 4 est, par exemple, un cristal photoréfractif du BaTi0₃, BSO ou GaAsQ.

En l'absence de l'émission du laser maître 1, la cavité 2 n'est pas refermée et le laser esclave ne fonctionne pas.

Le faisceau du laser maître 1 est envoyé sur le dispositif 4 en matériau non linéaire de manière à ce qu'il soit adapté à un mode spatial de la cavité 2. Dans l'exemple de la cavité de la figure 3, la direction est telle que ce faisceau maître Fm tienne lieu de faisceau sonde Fs pour le milieu non linéaire.

Après traversée du milieu non linéaire puis réflexion sur les miroirs M₁ et M₂, le faisceau sonde Fs traverse le milieu laser amplificateur 3. Après amplification, le faisceau sortant du milieu 3 sert de faisceau pompe Fp pour une interaction à deux ondes avec le faisceau sonde Fs, issu du laser maître, dans le milieu non linéaire. Grâce à l'interaction à deux ondes, une partie de l'énergie du faisceau pompe Fp est transférée sur le faisceau sonde Fs, et est donc de nouveau déviée vers le miroir M₂. La cavité 2 est donc refermée et l'effet laser prend place, verrouillé sur la phase et la fréquence du laser maître 1. Comme la phase à la sortie du milieu non linéaire (dispositif 4) est contrôlée uniquement par le maître, le verrouillage par injection est inconditionnel: il n'y a pas d'accord en fréquence nécessaire entre les modes des deux cavités, la phase de la cavité esclave s'adapte automatiquement sur celle du maître. Il n'est pas non plus nécessaire d'utiliser un isolateur entre le laser maître 1 et le laser esclave, car aucun retour du faisceau esclave ne se dirige vers le maître.

Le faisceau de sortie de la cavité peut être constitué de la partie du faisceau pompe non diffractée par le milieu non linéaire 4 (ordre zéro de diffraction) noté Fs1 sur le schéma.

On peut également prévoir que l'un des miroirs de la cavité M2 par exemple est semi-transparent. On peut alors extraire un faisceau de sortie noté Fs2 sur la figure 3.

On peut aussi noter que toute l'énergie du faisceau maître est couplée à la cavité esclave (il n'y a pas de retour par réflexion sur un miroir comme dans le cas classique), d'où un rendement d'injection maximum.

La figure 4 représente un autre exemple de réalisation du dispositif laser selon l'invention.

Dans ce dispositif, le laser esclave 3 est un réseau de lasers. Il est alors prévu une lentille cylindrique C pour adapter la taille du faisceau à la face utile d'entrée du réseau de laser 3. Les lentilles 01 et 02, situées de part et d'autre du laser esclave 3, permettent également la mise en forme du faisceau entrant et sortant du laser esclave.

Selon l'exemple de réalisation le dispositif 4 est en matériau nécessitant un angle relativement faible entre le faisceau sonde Fs et le faisceau pompe Fp.

A titre d'exemple, les différents éléments du dispositif de la figure 4 peuvent être réalisés de la manière suivante:
- laser maître 1: diode laser à semi-conducteur guidé par l'indice, P = 10 mW environ, monomode transverse et longitudinal
- laser esclave 3: réseau de 10 diodes lasers à semi-conducteurs guidés par le gain, P = 200 mW environ
- M₁, M₂, M₃: miroirs
- 0₁, 0₂, 0₃: objectifs de focalisation
- C: lentille cylindrique
- dispositif 4 en matériau non linéaire: cristal de titanate de Baryum nécessitant un angle de 20° environ entre le faisceau sonde (faisceau maître Fm) et le faisceau pompe (faisceau circulant dans la cavité 2).

Le dispositif laser 2 de l'invention trouve des applications dans les dispositifs suivants:
- sources de puissance limitée par diffraction à semi-conducteur (cas ou MLA est un réseau de diodes lasers);
- sources lasers stabilisées en fréquence sur un oscillateur local;
- toutes sources lasers verrouillées par injection.

## Revendications

1. Dispositif laser à cavité en anneau comprenant une cavité optique en anneau (2), un milieu amplificateur (3) situé dans la cavité optique (2), et constituant un laser esclave, un laser maître (1) émettant un faisceau lumineux (Fm) qui est injecté dans la cavité optique (2) pour commander le laser esclave, caractérisé en ce qu'il comprend un dispositif en matériau non linéaire (4) situé dans la cavité optique (2) recevant le faisceau lumineux du laser maître (1) qui joue le rôle de faisceau sonde (Fs) pour une interaction à deux ondes dans le matériau non linéaire, l'onde optique circulant dans la cavité optique jouant le rôle d'onde de pompe (Fp).

2. Dispositif laser selon la revendication 1, caractérisé en ce que la cavité optique en anneau comporte des dispositifs de réflexion (M1, M2, M3) pour refermer la cavité, le dispositif en matériau non linéaire (4) jouant également le rôle d'un dispositif de réflexion pour refermer la cavité en anneau.

3. Dispositif laser selon la revendication 2, caractérisé en ce que l'un dispositifs de réflexion (M1, M2, M3) est semi-réfléchissant pour permettre la sortie du faisceau (Fs) émis par la cavité en anneau.

4. Dispositif laser selon la revendication 1, caractérisé en ce que le dispositif en matériau non linéaire (4) permet la transmission d'une partie de l'énergie du faisceau circulant dans la cavité en anneau selon une direction colinéaire avec l'onde de pompe (Fp) du matériau non linéaire.

5. Dispositif laser selon la revendication 1, caractérisé en ce que le laser esclave est un réseau de laser, des dispositifs de focalisation (01, 02) étant associés à l'entrée et à la sortie du laser esclave.

6. Dispositif laser selon la revendication 1, caractérisé en ce que le dispositif en matériau non linéaire (4) est en BaTi0₃.

## Patentansprüche

1. Laservorrichtung mit Ringresonator mit einem ringförmigen optischen Resonator (2), einem Verstärkermedium (3), das in dem optischen Resonator (2) angebracht ist und einen abhängigen Laser bildet, einen Hauptlaser (1), der ein Lichtstrahlenbündel (Fm) aussendet, das in den optischen Resonator (2) zum Steuern des abhängigen Lasers eingeführt wird, gekennzeichnet durch eine Vorrichtung (4) aus nichtlinearem Material, die in dem optischen Resonator (2) angeordnet ist und das Lichtstrahlenbündel des Hauptlasers (1) empfängt, das die Rolle eines Sondenbündels (Fs) für eine Wechselwirkung mit zwei Wellen in dem nichtlinearen Material spielt, wobei die in dem Resonator zirkulierende optische Welle die Rolle der Pumpwelle (Fp) spielt.

2. Laservorrichtung nach Anspruch 1, dadurch gekennzeichnet, daß der ringförmige optische Resonator zum Abschließen des Resonators Reflexionsvorrichtungen (M1, M2, M3) enthält, wobei die Vorrichtung (4) aus nichtlinearem Material ebenfalls die Rolle einer Reflexionsvorrichtung zum Abschließen des ringförmigen Resonators spielt.

3. Laservorrichtung nach Anspruch 2, dadurch gekennzeichnet, daß eine Reflexionsvorrichtung (M1, M2, M3) halbreflektierend ist, damit das von dem ringförmigen Resonator ausgesendete Strahlenbündel (FS) austreten kann.

4. Laservorrichtung nach Anspruch 1, dadurch gekennzeichnet, daß die Vorrichtung (4) aus nichtlinearem Material die Übertragung eines Teils der Energie des in dem ringförmigen Resonator zirkulierenden Strahlenbündels in eine kolinear mit der Pumpwelle (Fp) des nichtlinearen Materials verlaufende Richtung ermöglicht.

5. Laservorrichtung nach Anspruch 1, dadurch gekennzeichnet, daß der abhängige Laser ein Lasergitter ist, wobei dem Eingang und dem Ausgang des abhängigen Lasers Fokussierungsvorrichtungen (01, 02) zugeordnet sind.

6. Laservorrichtung nach Anspruch 1, dadurch gekennzeichnet, daß die Vorrichtung (4) aus nichtlinearem Material BaTiO₃ besteht.

## Claims

1. Laser device with ring-configured cavity, comprising a ring-configured optical cavity (2), an amplifying medium (3) located in the optical cavity (2), and constituting a slave laser, a master laser (1) emitting a light beam (Fₘ) which is injected into the optical cavity (2) in order to control the slave laser, characterised in that it comprises a device (4) made of non-linear material located in the optical cavity (2) receiving the light beam from the master laser (1) which acts as probe beam (Fₛ) for a two-wave interaction in the non-linear material, the optical wave circulating in the optical cavity acting as pump wave (Fₚ).

2. Laser device according to Claim 1, characterised in that the ring-configured optical cavity includes reflection devices (M₁, M₂, M₃) for closing off the cavity, the device (4) made of non-linear material also acting as a reflection device for closing off the ring-configured cavity.

3. Laser device according to Claim 2, characterised in that one of the reflection devices (M₁, M₂, M₃) is semi-reflective in order to permit the output of the beam semi-reflective in order to permit the output of the beam (Fₛ) emitted by the ring-configured cavity.

4. Laser device according to Claim 1, characterised in that the device (4) made of non-linear material permits the transmission of part of the energy of the beam circulating in the ring-configured cavity in a direction collinear with the pump wave (Fₚ) of the nonlinear material.

5. Laser device according to Claim 1, characterised in that the slave laser is a laser array, focusing devices (O₁, O₂) being associated with the input and with the output of the slave laser.

6. Laser device according to Claim 1, characterised in that the device (4) made of non-linear material is made of BaTiO₃.
